# EUROPEAN PATENT APPLICATION

(11) **EP 4 841 671 A1**
(43) Date of publication of application: **18.11.2026**
(21) Application number: 25177010.3
(22) Date of filing: 16.05.2025
(51) Int. Cl.: H01J 37/28, H01J 37/09

(54) **CHARGED PARTICLE-OPTICAL ELEMENT**

(71) Applicant: ASML Netherlands B.V., 5500 AH Veldhoven (NL)
(72) Inventor: ZOLOTAREV, Evgeny, 5500 AH Veldhoven (NL); ANNEMA, Piter, Hessel, 5500 AH Veldhoven (NL)
(74) Representative: ASML Netherlands B.V.

(57) **Abstract**

A charged particle-optical element 261 for a charged particle-optical device, the charged particle-optical device configured to direct a plurality of charged particle beams 211, 26 towards a sample location, the charged particle-optical element comprising: a first region 10 for passage of the plurality of charged particle beams; and a second region 20 adjacent the first region for blocking at least a subset 26 of the plurality of charged particle beams, wherein the second region comprises surface features 51 on an upbeam surface 52 of the charged particle-optical element for reducing an angular spread 27 of charged particles emitted from the upbeam surface upon incidence of the subset of the plurality of charged particle beams on the surface features.

## Description

### FIELD

The present invention relates to a charged particle-optical element, a stack of charged particle-optical elements, a charged particle-optical assembly, a charged particle-optical device, a charged particle-optical apparatus and a method for making a charged particle-optical element.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as an electron beam) which may, for example, be scanned across a part of the substrate (such as in a scanning electron microscopes (SEMs)). Collecting interaction products that result from the interaction of the electron beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

A plurality of electron beams may be used at the same time so as to reduce the time taken to asses a sample. The electron beams may be provided in an array which may be referred to as a beam grid. Charged particles such as secondary electrons beyond the beam grid can degrade the performance of the system. For example, components can become undesirably charged. As another example, the charged particles can encourage growth of materials such as hydrocarbon on components. The charging and the material grid can reduce the performance of the system.

### SUMMARY

It is desirable to reduce the negative effects of charged particles beyond the beam gird of the multi-beam system.

An embodiment of the present disclosure provides a charged particle-optical element for a charged particle-optical device, the charged particle-optical device configured to direct a plurality of charged particle beams towards a sample location, the charged particle-optical element comprising a plurality of apertures for passage therethrough of the plurality of charged particle beams;
wherein an upbeam surface of the charged particle-optical element comprises surface features configured to reduce a spread of charged particles emitted from the upbeam surface upon incidence of one or more of the plurality of charged particle beams on at least a subset of the said surface features.

An embodiment of the present disclosure provides a method for making a charged particle-optical element for a charged particle-optical device, the charged particle-optical device configured to direct a plurality of charged particle beams towards a sample location, the method comprising:
defining in the charged particle-optical element a plurality of apertures for passage therethrough of the charged particle beams; and
forming an upbeam surface of the charged particle-optical element to comprise surface features configured to reduce a spread of charged particles emitted from the upbeam surface upon incidence of one or more of the plurality of charged particle beams on at least a subset of the said surface features.

An embodiment of the present disclosure provides a charged particle-optical element for a charged particle-optical device, the charged particle-optical device configured to direct a plurality of charged particle beams towards a sample location, the charged particle-optical element comprising:
a first region for passage of the plurality of charged particle beams; and
a second region adjacent the first region for blocking at least a subset of the plurality of charged particle beams, wherein the second region comprises surface features on an upbeam surface of the charged particle-optical element for reducing an angular spread of charged particles emitted from the upbeam surface upon incidence of a subset of the plurality of charged particle beams on the surface features.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts a charged particle-optical element for reducing a spread of charged particles;
- Figure 7 schematically depicts a comparative example; and
- Figure 8 is a schematic close up of a surface feature of the charged particle-optical element shown in Figure 6, for example.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

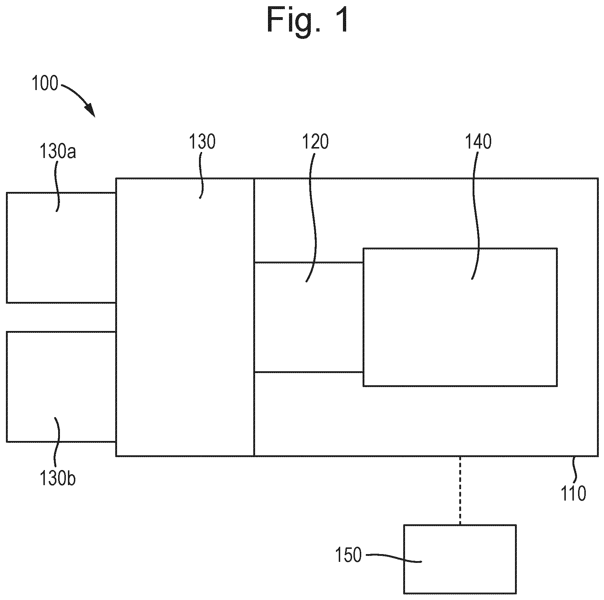

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

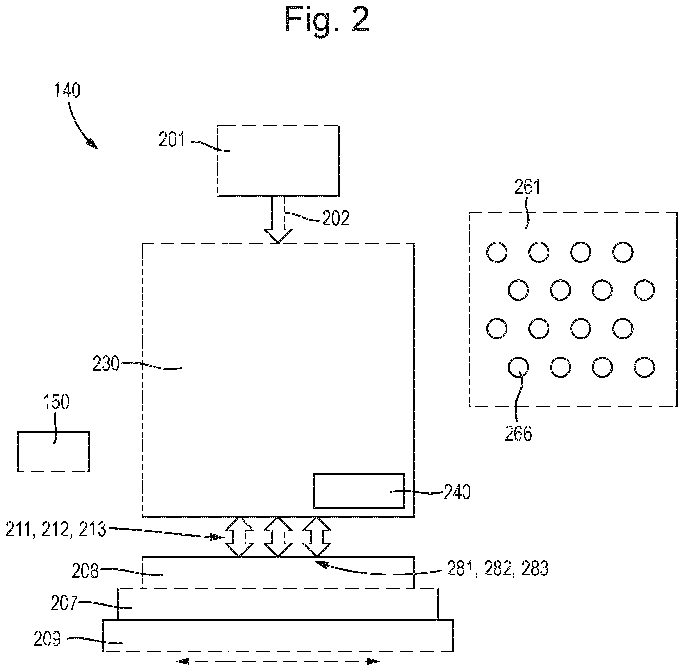

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of electron beams 211, 212, 213 (which may be referred to as primary beams, sub-beams or beamlets). The electron-optical device 230 may be configured to direct the electron beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the electron beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more apertures 266 (which may be referred to as primary apertures, beam apertures or electron beam apertures) may be defined in the plates 261 for the passage of one or more beams. The apertures 266 may be arranged in a pattern such as a regular grid e.g. hexagonal or square. Such a pattern of the apertures 266 may be referred to as an aperture array (i.e. a two-dimensional array over the surface of the plate). The pattern of the apertures 266 may correspond to the pattern of beams within the beam grid. Apertures 266 in different plates operating on the same beam(s) are typically aligned.

The electron-optical elements may comprise one or more corrector arrays. For example, a corrector array may be integrated into the shape, position and/or size of the apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the electron beams 211, 212, 213 so as to scan the probe spots 281, 282, 283 across individual scanning areas of the sample 208. In response to incidence of the electron beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the electron beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the electron beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around apertures 266 in the bottom surface of the electron-optical device 230 to allow the electron beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

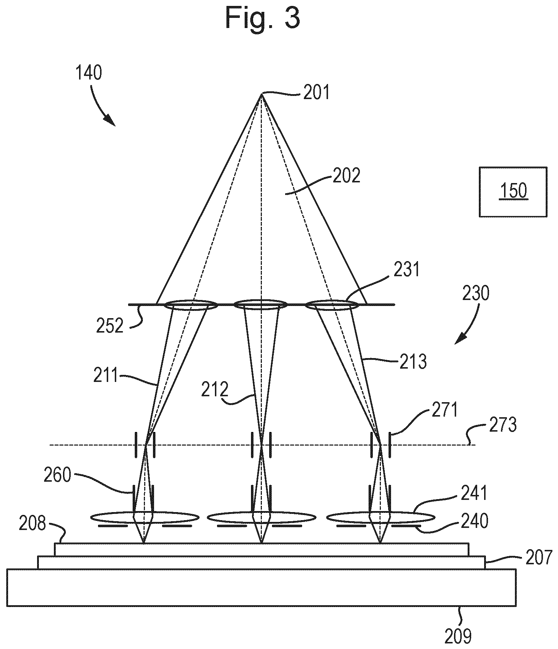

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of electron beams 211, 212, 213 from the source beam 202. The condenser lens array 231 focuses the electron beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the electron beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective electron beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the apertures 266, such as on the surface around the apertures 266 and/or on the inside of the apertures 266. The electrodes may cooperate as a deflector per aperture 266. Alternatively, the collimator array 271 may comprise a stack of plates 261. In use a potential difference is applied between the plates 261 so as to generate a lensing effect at the apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the electron beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the electron beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the electron beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the electron beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

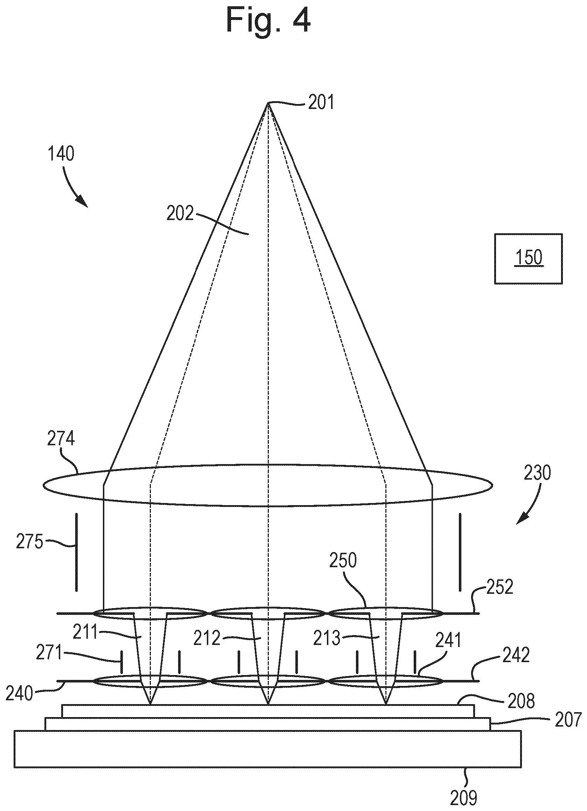

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the electron beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of electron beams 211, 212, 213 from the source beam 202. The beam shaper array 242 and the beam limiting aperture array 252 are plates 261 in which the apertures 266 are smaller in dimension than other plates of the electron-optical device 230. The apertures 266 of the beam limiting aperture array 252 define the electron beams 211, 212, 213. The apertures 266 of the beam shaper array 242 shape the electron beams 211, 212, 213 to at least partially correct for types of aberration in the beams.

The collimator array 271 is configured to collimate the electron beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective electron beams 211, 212, 213. The collimator array 271 may be electrostatic. The collimator array 271 may consist of a single plate 261 comprising the deflectors around the apertures 266, for example on the surface around the apertures 266 and/or on the inside of the apertures 266. Alternatively, the collimator array 271 may comprise a stack of plates 261. In use a potential difference is applied between the plates 261 so as to generate a lensing effect at the apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the electron beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the electron beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the electron beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

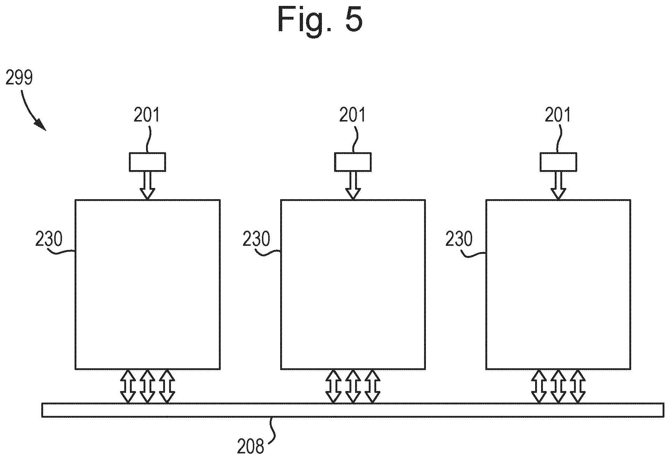

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

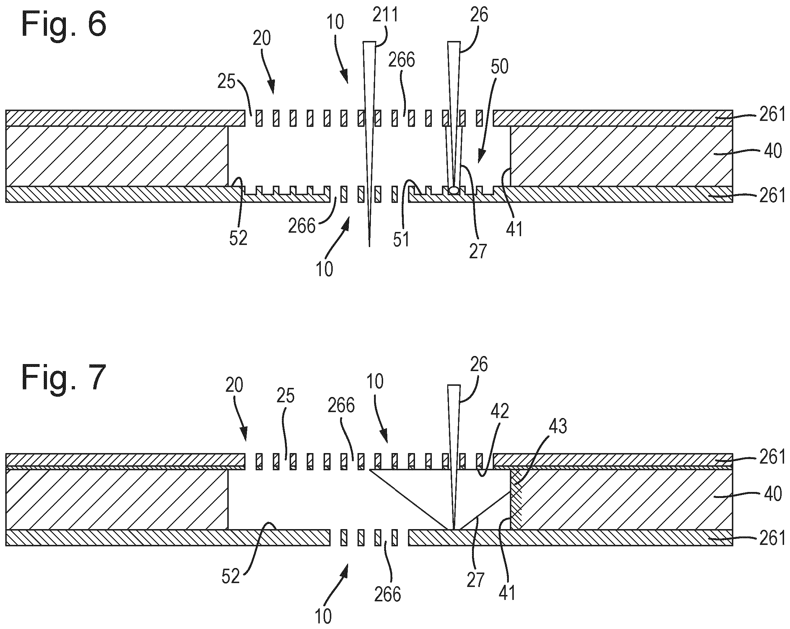

Figure 6 schematically depicts an electron-optical element. The electron-optical element may be substantially planar. In an embodiment, the electron-optical element takes the form of a plate 261. In another embodiment, the electron-optical element may be curved or partially curved. The invention is described primarily in the context of the electron-optical element being shaped as a plate 261.

In the arrangement shown in Figure 6, the electron-optical element is stacked together with an upbeam plate 261 (shown at the top of Figure 6). The plates 261 are spaced from each other by an isolator 40.

In an embodiment, the stack of electrical-optical elements (e.g. plates 261) is part of an electron-optical assembly such as an objective lens assembly. The stack may comprise electron-optical elements that form objective lenses, for example, focussing the electron beams onto a sample 208. In an embodiment the electron-optical element is the most upbeam electron-optical element of the stack, for example the objective lens assembly. An embodiment of the invention is expected to reduce upbeam scattering towards parts of the electron-optical device 230 that are upbeam of the stack. The structure of the electron-optical element can reduce a spread of electrons (e.g. secondary electrons and/or backscattered electrons) upbeam of the electron-optical assembly.

As shown in Figure 6, the electron-optical element comprises a plurality of apertures 266 for passage therethrough of the electron beams. In Figure 6, one electron beam 211 is shown. Only one electron beam 211 is shown merely for convenience.

As shown in Figure 6, in an embodiment the electron-optical element comprises a functional region 10 (which may be referred to as a first region). The functional region 10 is defined by the apertures 266 through which the electron beams 211 pass. The functional region 10 has the shape of the beam gird, i.e. the two-dimensional array of apertures 266. The functional region 10 can be defined as the region having a plurality of apertures 266 for passage of the set of electron beams 211 that are directed onto the sample 208. In an alternative embodiment, the functional region 10 can be defined by the inspection grid, that is the grid that determines the electron beams being detected for purposes of assessing (for example inspecting) the sample 208.

As shown in Figure 6, in an embodiment, the electron-optical element (shown as the plate 261 at the bottom of Figure 6) comprises an upbeam surface 52. The upbeam surface 52 faces the upbeam plate 261 of the stack. The electron-optical element may further comprise a downbeam surface (for example the surface facing downwards in Figure 6).

As shown in Figure 6, in an embodiment, the upbeam surface 52 of the electron-optical element comprises surface features 51. The surface features 51 are provided at the upbeam surface 52. The surface features 51 may be formed by shaping or treating the upbeam surface 52 of the electron-optical element.

In an embodiment, the surface features 51 are configured to reduce a spread of electrons emitted from the upbeam surface 52. The surface features 51 may be configured to reduce an angular distribution of electrons emitted from the upbeam surface 52. The surface features 51 may be configured to reduce scattering of electrons emitted from the upbeam surface 52. In an embodiment the surface features 51 are configured to reduce a flux of electrons emitted from the upbeam surface 52. In the presence of a stack of electron-optical elements (for example plates 261), the reduction in flux will also mean a reduction in current.

Such electrons may be emitted from the upbeam surface 52 upon incidence of one or more of the plurality of electron beams on at least a subset of the surface features 51. For example, as shown in Figure 6, electrons may be incident on the upbeam surface 52. Figure 6 schematically shows a non-functional beam 26 of electrons. The upbeam surface 52 is in the path of the non-functional beam 26. The non-functional beam 26 is referred to as being non-functional because the non-functional beam 26 is not for assessing the sample 208. The non-functional beam 26 is blocked or otherwise prevented from reaching the surface of the sample 208. For example, as shown in Figure 6, the upbeam surface 52 of the electron-optical element may block the non-functional beam 26.

As a result of the electrons in the non-functional beam 26, electrons (e.g. secondary electrons and/or backscattered electrons) may emanate from the upbeam surface 52 of the electron-optical element. For example, Figure 6 schematically shows an emission cone 27 of electrons emitted from the upbeam surface 52. In an embodiment, the surface features 51 are configured to reduce the spread of these electrons from the upbeam surface 52. That is, the surface features 51 are configured to reduce the spread of the emitted electrons compared to if the surface features 51 were not provided. If the surface features were not provided, then the upbeam surface 52 radially outward of the functional region 10 would be substantially planar (e.g. as shown in comparative example in Figure 7).

Figure 7 schematically depicts a comparative example. In the comparative example, the upbeam plate 261 (shown at the top of Figure 7) and the isolator 40 are identical to those shown in Figure 6. However, the bound beam plate 261 (shown at the bottom of Figure 7) is different from the electron-optical element shown at the bottom of Figure 6. The downbeam plate 261 shown in Figure 7 does not have the surface features 51 shown in Figure 6.

A comparison between Figure 6 and Figure 7 helps to illustrate the effect of the surface features 51. As shown in Figure 7, the emission cone 27 of emitted electrons from the upbeam surface 52 is wider than the emission cone 27 of emitted electrons from the upbeam surface 52 shown in Figure 6. The emitted electrons spread more widely in the arrangement shown in Figure 7 compared to in the arrangement shown in Figure 6. This is because the surface features 51 shown in Figure 6 reduce the spread of the emitted electrons from the upbeam surface 52.

An embodiment of the invention is expected to improve the performance of an electron-optical device 230 comprising the electron-optical element. One cause of degradation of performance can be the undesirable growth of material on components of the electron-optical device 230. For example, electrons can induce the deposition of materials on components. This is shown in Figure 7 where material 42 is grown in the downbeam surface of the upbeam plate 261. For example, the material 42 may comprises hydrocarbon. The growth of the material 42 may be induced by the emitted electrons from the upbeam surface 52 of the electrical-optical element. This may be referred to as E-beam induced deposition. The growth of the material 42 may reduce the performance of the electron-optical device 230 comprising the stack of plates 261. By reducing the spread and/or current of the emitted electrons from the upbeam surface 52, the extent of growth of the material 42 may be reduced, thereby reducing the degradation of performance.

As shown in Figure 6, in an embodiment the upbeam plate 261 comprises a non-functional region 20 beyond the functional region 10. The non-functional region 20 may comprise non-functional apertures 25. The non-functional apertures 25 may have non-functional beams 26 passing through them. The non-functional beams 26 may be referred to as dummy beams, for example. The non-functional region 20 is radially outward of the functional region 10. In an embodiment, the non-functional region 20 substantially surrounds the functional region 10.

As shown from a comparison between Figure 6 and Figure 7, in an embodiment the surface features 51 are configured to narrow an emission cone 27 of emitted electrons produced in the electron-optical element (i.e. the downbeam plate 261). The electrons may be emitted from the upbeam surface 52 upon incidence of the one or more of the plurality of electron beams on the surface features 51. By narrowing the emission cone 27 of emitted electrons, the area of the downbeam surface of the upbeam plate 261 in which the emitted electrons are incident may be reduced. This may reduce of the growth of material 42 on the downbeam surface of the upbeam plate 261.

In an embodiment the surface features are provided in a blocking region (which may be referred to as a second region) of the downbeam plate 261. As shown in Figure 6, in an embodiment the surface features 51 are adjacent a first region comprising the plurality of apertures 266. As shown in Figure 6, in an embodiment the surface features 51 are radially outward of the apertures 266. In an embodiment, the surface features 51 substantially surround the apertures 266. For example, the surface features 51 may be provided on all sides (when viewed in plan view) of the functional region 10.

It is not essential for the surface features 51 to be adjacent the first region. For example, the surface features may be distanced from the first region comprising the plurality of apertures 266. An intermediate region may be provided between the first region and the surface features 51.

As shown in Figure 6, in an embodiment, the surface features 51 are features of the shape of the upbeam surface 52. In an embodiment, the surface features 51 have diameters. In an embodiment, the dimeter of the surface features 51 is similar (e.g. at least 50%, optionally at least 80%, optionally at least 90%, optionally at least 95% of the diameters of the apertures 266 at the radially outward edge of the functional region 10. In an embodiment, the dimeters of the surface features 51 are substantially equal to the diameters of the apertures 266 at the radially outward part of the functional region 10. In an embodiment, the surface features 51 have diameters that are at most 200%, optionally at most 150%, optionally at most 120%, optionally at most 110% and optionally at most 105% of the diameters of the apertures 266 at the edge of the functional region 10. In an embodiment, the surface features 51 have diameters that are at most 200%, optionally at most 150%, optionally at most 120%, optionally at most 110% and optionally at most 105% of the diameters of the apertures 266 at the edge of the functional region 10.

In an embodiment, the surface features 51 have a shape, in plan view, similar to the shapes of the apertures 266. For example, the primary features 266 and the surface features 51 may be substantially circular when viewed in plan view. In an alternative embodiment, the apertures 266 and the surface features 51 may be substantially elliptical when viewed in plan view.

In an embodiment, the spacing between the surface features 51 may be similar to the spacing between the apertures 266. For example, the spacing between the surface features 51 may be at least 50%, optionally at least 80%, optionally at least 90% and optionally at least 95% of the spacing between the apertures 266 near the edge of the functional region 10. In an embodiment, the spacing between the surface features 51 is substantially equal to the spacing between the apertures 266 in periphery of the functional region 10. In an embodiment, the spacing between the surface features is at most 200%, optionally at most 150%, optionally at most 120%, optionally at most 110% and optionally at most 105% of the spacing between the apertures 266 near the edge of the functional region 20.

By providing that one or more of the diameter, shape and spacing of the surface features 51 is similar to those of the apertures 266, edge effects as a result of changes at the edge of the beam grid may be reduced. For example, the electric field near the edge of the functional region 10 may be made more uniform. The surface features 51 may be configured to increase uniformity of the electric fields adjacent to the functional region 10. The surface features 51 may be configured to reduce or avoid sudden changes in the parameters at the edge of the functional region 10. This may help to reduce undesirable effects on the electric field strength caused by discontinuities in parameters at the edge of the functional region 10.

However, it is not essential for the surface features 51 to be configured to increase the uniformity of the electric field at the edge of the functional region 10. In an alternative embodiment, the surface features 51 are designed solely for reducing a spread of the emitted electrons from the upbeam surface 52 of the electron-optical element.

By providing that the surface features 51 are radially outward of the apertures 266, the surface features 51 may be provided in a region at which the non-functional beams 26 are expected to be incident. In an embodiment, the surface features 51 are configured to block the non-functional beams 26 from reaching sample 208. The surface features may be provided in a region at which emitted electrons are particularly expected to be produced. The surface features 51 may be located where they aren't expected to have the greatest effect in reducing the spread of emitted electrons. As shown in Figure 6, in an embodiment the surface features 51 comprise recessed portions. For example, the surface features 51 may comprise as dimples or depressions.

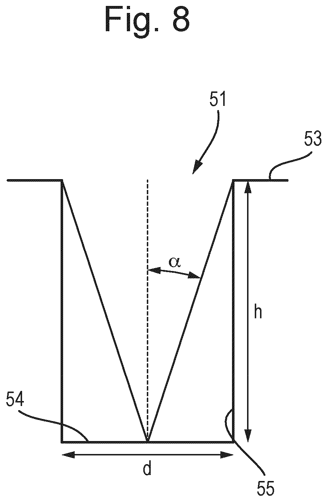

Figure 8 is a schematic close up view of a surface feature 51, for example, of the electron-optical elements shown in Figure 6. As shown in Figure 8, in an embodiment the upbeam surface 52 has a nominal plane 53. In an embodiment, the majority of the upbeam surface 52 is at the nominal plane 53. The surface feature 51 may be a recessed portion, that is recessed relative to the nominal surface 53. In an embodiment at least one of the surface features 51 comprises a recessed portion, that is recessed relative to the nominal surface 53. In an embodiment at least one of the surface features 51 comprises a dimple.

By providing the recessed portion, the emission cone 27 of emitted electrons may be restricted to a smaller opening angle. This reduces the area over which the emitted electrons can be incident on upbeam components such as the upbeam plate 261 shown in Figure 6.

As shown in Figure 8, in an embodiment, the surface feature 51 has a diameter d and a height h. The dimeter d and the height h may be selected so as to control the shape of the emission cone 27 of emitted electrons produced in the electron-optical element. The height h ay alternatively be referred to as the depth of the surface feature 51. In an embodiment, a ratio of a depth (or height h) of the recessed (or concave) portions to a diameter d of the recessed (or concave) portions, is at least 0.5, optionally at least 1, optionally at least 2, and optionally at least 5. By increasing the ratio of the height h to the diameter d, the opening angle to which the emission cone 27 of emitted electrons is restricted may be reduced. In Figure 8, the opening angle is labelled as α.

Figure 8 schematically depicts the opening angle α when the non-functional beam 26 is focussed on the centre of the surface feature 51. It may be that the non-functional beam 26 is not focussed on the centre of the surface feature 51. For example, the non-functional beam 26 may be defocussed and may potentially substantially fill the entire floor (i.e. bottom 54) of the surface feature 51. The opening angle to which the emission cone 27 would be restricted would then be doubled to 2α. Typically, the opening angle to which the emission cone 27 may be expected to be restricted is greater than α and less than 2α.

As shown in Figure 8, in an embodiment the surface feature 51 comprises at least one wall 55. In the arrangement shown in Figure 8, the wall 55 is substantially perpendicular to the nominal plane 53 of the upbeam surface 52. However, it is not essential for the wall 55 to be perpendicular to the nominal plane 53. In an alternative embodiment the wall 55 may be angled relative to the nominal plane 53. For example, the width of the surface feature 51 may reduce when going in a direction away from the nominal plane 53. That is, the surface feature 51 may taper towards the bottom 54 of the surface feature 51. In an embodiment, the surface feature 51 is substantially cone-shaped. For example, the cross-sectional shape of the surface feature 51 may be V-shaped. As shown in Figure 8, in an embodiment the wall 55 is substantially straight. In an alternative embodiment the wall 55 is curved or partially curved. For example, the wall may be C-shaped.

The surface features 51 may be referred to as cups because of their shape. The surface features 51 nay be microscopic cups to capture the non-functional beams 26.

In an embodiment the surface features 51 are treated so as to further reduce the spread of the emitted electrons. By further reducing the spread, the possibility of degradation of the performance of the electron-optical device 230 may be further reduced.

In an embodiment, the electron-optical element comprises a coating with which the surface features 52 are treated. The coating is configured to limit the number of emitted electrons. In an embodiment the coating is applied by sputtering and/or evaporation techniques. By providing the additional coating, the surface features 51 (i.e. structures) can further reduce spread of emitted electrons.

As shown in the comparative example of Figure 7, it is possible that the emission cone 27 of emitted electrons from the upbeam surface 52 may undesirably reach the apertures 266 within the functional region 10 of the upbeam plate 261. This can undesirably reduce the growth of hydrocarbons and the downbeam surface within the functional region 10 of the upbeam plate 261.

In an embodiment, the surface features 51 are configured to reduce a spread (e.g. scattering) of emitted electrons to the apertures 266 within the functional region 10 of the upbeam plate 261. For an example, in an embodiment, the aspect ratio (i.e. the ratio height h to the dimeter d) of the surface feature 51 may be selected so as to reduce the possibility of (or avoid all together) the emitted electrons from the upbeam surface 52 reaching the functional region 10 of the upbeam plate 261.

As shown in Figure 6, in an embodiment the isolator 40 is configured to substantially isolate the electron-optical element from the upbeam plate 261. In an embodiment, one or more further isolators are provided for isolating the electron-optical element from other plates 261 of the stack. In an embodiment, the isolator 40 is configured to mechanically support the electron-optical element. For example, the isolator 14 may be configured to fix the position of the electron-optical element relative to the upbeam plate 261. In an embodiment, the isolator 40 is configured to define the spacing, in the direction along the electron beams 211, between the plates 261 of the stack. As shown in Figure 6, in an embodiment, the isolator 40 is arranged around the functional region 10. In an embodiment, the isolator 40 is arranged around the non-functional region 20. The inner surface 41 of the isolator may be provided at or near the outer edge of the non-functional region 20. In plan view, the inner surface 41 of the isolator 40 may appear to be substantially circular. It is not essential for the inner surface 41 to be circular in plan view. For example, in an alternative arrangement, the inner surface 41 may be polygonal, for example hexagonal.

As shown in Figure 7, there is a possibility that the emission cone 27 of emitted electrons from the upbeam surface 52 of the electron-optical element may reach the inner surface 41 of the isolator 40. When such electrons reach the inner surface 41 of the isolator 40, it is possible that the electrons can undesirably charge the isolator 40. In an embodiment, the isolator 40 comprises a dielectric material. The dielectric material may be charged when the emitted electrons are incident on it. Such charging may be undesirable. For example, such charging may undesirably affect the electric fields that are adjacent to he functional region 10. It is possible that such may increase the possibility of electrical breakdown.

As shown in Figure 6, in an embodiment, the surface features 51 are configured to reduce a spread (e.g. scattering) of emitted electrons onto the isolator 40. For example, in the arrangement shown in Figure 6, the emission cone 27 of emitted electrons does not reach the inner surface 41 if the isolator 40. In an embodiment, the ratio between the height h and the diameter d of the surface features 51 is selected so as to reduce or avoid the possibility of the emission cone 27 of emitted electrons reaching the inner surface 41 of the isolator 40.

In Figure 7, the growth of material 42 is shown at the downbeam surface of the upbeam plate 261, and the undesirable charging 43 is shown at the inner surface 41 of the isolator 40. It is possible that the growth of such material 42 may occur at one or more other surfaces of the electron-optical device 230. It is possible that undesirable charging 43 may occur at other surfaces of the electron-optical devices 130. An embodiment of the invention is expected to reduce undesirable charging within the electron-optical device 230. An embodiment of the invention is expected to reduce undesirable growth of material one components of the electron-optical device 230. An embodiment of the invention is expected to improve the performance of an electron-optical device 230 comprising the electron-optical element.

A method of making the electron-optical element may comprises defining in the electron-optical element a plurality of apertures 266 for passage therethrough of the electron beams 211. For example, the apertures 266 may be etched, or otherwise machined.

In an embodiment, the method for making the electron-optical element comprises forming an upbeam surface 52 of the electron-optical element to comprises surface features 51, configured to reduce a spread of secondary electron from the upbeam surface 52. For example, the surface features 51 may be formed by an etching process. The etching process may be stopped before the full thickness of the plate 251 is etched through, so as to ensure that the surface features 51 are surface features rather than apertures. The precise shape of the surface features 51 may be dependent the etching process sued to form the surface features 51.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Exemplary embodiments of the present disclosure are set out in the following numbered clauses:
1. A charged particle-optical element for a charged particle-optical device, the charged particle-optical device configured to direct a plurality of charged particle beams towards a sample location, the charged particle-optical element comprising a plurality of apertures for passage therethrough of the plurality of charged particle beams;
   wherein an upbeam surface of the charged particle-optical element comprises surface features configured to reduce a spread of charged particles emitted from the upbeam surface upon incidence of one or more of the plurality of charged particle beams on at least a subset of the said surface features.
2. The charged particle-optical element of clause 1, wherein the surface features are configured to narrow an emission cone of the charged particles emitted from the upbeam surface upon incidence of the one or more of the plurality of charged particle beams on at least a subset of the said surface features.
3. The charged particle-optical element of clause 1 or 2, wherein the surface features are adjacent a first region comprising the plurality of apertures.
4. The charged particle-optical element of any preceding clause, wherein the surface features are radially outward of the plurality of apertures.
5. The charged particle-optical element of any preceding clause, wherein the surface features comprise recessed portions.
6. The charged particle-optical element of clause 5, wherein a ratio of a depth of the recessed portions to a diameter of the recessed portions is at least 0.5, optionally at least 1, optionally at least 2 and optionally at least 5.
7. The charged particle-optical element of any preceding clause, wherein the surface features comprise concave portions.
8. The charged particle-optical element of any preceding clause, wherein the surface features comprise dimples.
9. The charged particle-optical element of any preceding clause, wherein the surface features are treated so as to further reduce the spread.
10. The charged particle-optical element of clause 9, comprising a coating with which the surface features are treated.
11. The charged particle-optical element of any preceding clause, wherein the surface features are further configured to reduce a flux of charged particles emitted from the upbeam surface upon incidence of one or more of the plurality of charged particle beams.
12. A stack of charged particle-optical elements comprising the charged particle-optical element of any preceding clause and at least one other charged particle-optical element upbeam of the charged particle-optical element.
13. The stack of clause 12, wherein the at least one other charged particle-optical element comprises a plurality of dummy apertures for passage therethrough of dummy beams of charged particles, wherein the surface features of the charged particle-optical element are configured to block the dummy beams from reaching the sample location.
14. The stack of clause 12 or 13, wherein the at least one other charged particle-optical element comprises a plurality of other apertures for passage therethrough of the plurality of charged particle beams, wherein the surface features are configured to reduce the spread of charged particles emitted from the upbeam surface to the other apertures.
15. The stack of any of clauses 12-14, comprising an isolator configured to substantially isolate the charged particle-optical element from the at least one other charged particle-optical element.
16. The stack of clause 15, wherein the surface features are configured to reduce the spread of charged particles emitted from the upbeam surface onto the isolator.
17. A charged particle-optical assembly comprising the stack of any of clauses 12-16.
18. The charged particle-optical assembly of clause 17, forming a plurality of objective lenses configured to direct the charged particle beams onto the sample location.
19. A charged particle-optical device comprising the charged particle-optical assembly of clause 17 or 18.
20. A charged particle-optical apparatus comprising:
   the charged particle-optical device of clause 19; and
   an actuatable stage configured to support a sample at the sample location.
21. A method for making a charged particle-optical element for a charged particle-optical device, the charged particle-optical device configured to direct a plurality of charged particle beams towards a sample location, the method comprising:
   defining in the charged particle-optical element a plurality of apertures for passage therethrough of the charged particle beams; and
   forming an upbeam surface of the charged particle-optical element to comprise surface features configured to reduce a spread of charged particles emitted from the upbeam surface upon incidence of one or more of the plurality of charged particle beams on at least a subset of the said surface features.
22. A charged particle-optical element for a charged particle-optical device, the charged particle-optical device configured to direct a plurality of charged particle beams towards a sample location, the charged particle-optical element comprising:
   a first region for passage of the plurality of charged particle beams; and
   a second region adjacent the first region for blocking at least a subset of the plurality of charged particle beams, wherein the second region comprises surface features on an upbeam surface of the charged particle-optical element for reducing an angular spread of charged particles emitted from the upbeam surface upon incidence of a subset of the plurality of charged particle beams on the surface features.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A charged particle-optical element for a charged particle-optical device, the charged particle-optical device configured to direct a plurality of charged particle beams towards a sample location, the charged particle-optical element comprising a plurality of apertures for passage therethrough of the plurality of charged particle beams;
wherein an upbeam surface of the charged particle-optical element comprises surface features configured to reduce a spread of charged particles emitted from the upbeam surface upon incidence of one or more of the plurality of charged particle beams on at least a subset of the said surface features.

2. The charged particle-optical element of claim 1, wherein the surface features are configured to narrow an emission cone of the charged particles emitted from the upbeam surface upon incidence of the one or more of the plurality of charged particle beams on at least a subset of the said surface features.

3. The charged particle-optical element of claim 1 or 2, wherein the surface features are adjacent a first region comprising the plurality of apertures.

4. The charged particle-optical element of any preceding claim, wherein the surface features are radially outward of the plurality of apertures.

5. The charged particle-optical element of any preceding claim, wherein the surface features comprise:
(i) recessed portions;
(ii) concave portions; and/or
(iii) dimples

6. The charged particle-optical element of any preceding claim, wherein the surface features are treated so as to further reduce the spread.

7. The charged particle-optical element of claim 6, comprising a coating with which the surface features are treated.

8. A stack of charged particle-optical elements comprising the charged particle-optical element of any preceding claim and at least one other charged particle-optical element upbeam of the charged particle-optical element.

9. The stack of claim 8, wherein the at least one other charged particle-optical element comprises a plurality of dummy apertures for passage therethrough of dummy beams of charged particles, wherein the surface features of the charged particle-optical element are configured to block the dummy beams from reaching the sample location.

10. The stack of claim 8 or 9, wherein the at least one other charged particle-optical element comprises a plurality of other apertures for passage therethrough of the plurality of charged particle beams, wherein the surface features are configured to reduce the spread of charged particles emitted from the upbeam surface to the other apertures.

11. The stack of any of claims 8-10, comprising an isolator configured to substantially isolate the charged particle-optical element from the at least one other charged particle-optical element.

12. The stack of claim **11,** wherein the surface features are configured to reduce the spread of charged particles emitted from the upbeam surface onto the isolator.

13. A charged particle-optical assembly comprising the stack of any of claims 8-12.

14. The charged particle-optical assembly of claim 13, forming a plurality of objective lenses configured to direct the charged particle beams onto the sample location.

15. A charged particle-optical apparatus comprising:
the charged particle-optical assembly of claim 14; and
an actuatable stage configured to support a sample at the sample location.
